# EUROPEAN PATENT APPLICATION

(11) **EP 4 580 061 A1**
(43) Date of publication of application: **02.07.2025**
(21) Application number: 24215131.4
(22) Date of filing: 25.11.2024
(51) Int. Cl.: H03K 17/96, A47L 15/42

(54) **A HOUSEHOLD APPLIANCE COMPRISING A TOUCH PANEL**

(30) Priority: 28.12.2023 TR 202319275
(71) Applicant: Arçelik Anonim Sirketi, 34445 Istanbul (TR)
(72) Inventor: DIKSAN, MEHMET, 34445 ISTANBUL (TR); DIK, ENGIN, 34445 ISTANBUL (TR); CENNETKUSU, MEHMET, 34445 ISTANBUL (TR)

(57) **Abstract**

The present invention relates to a household appliance (1) comprising a body (2); a control panel (3) which is disposed on the body (2) and which enables the user to control the programs; a reflector (4) which is provided on the control panel (3); a light source panel (5) which is disposed behind the reflector (4); a plurality of cut-outs (6) which are provided on the reflector (4) and which enable the light coming from the light source to be transmitted; at least one silkscreen foil (7) which is disposed in front of the reflector (4) and which has signs and information thereon; a diffuser (8) which is disposed in front of the silkscreen foil (7); a glass (9) which is disposed in front of the diffuser (8); and a control unit (10) which controls the operation of the programs.

## Description

The present invention relates to a household appliance comprising a touch panel.

In the household appliances, there are various features and programs in order to run the functions of the appliance. The user can select the appropriate program and the features he/she wants to use from among these. In order for the user to select the feature he/she wants, all the programs and features must be shown to the user on the panel. In the state of the art applications, the control process is performed by means of a screen, buttons and LEDs. The household appliance is controlled by means of various components on the panel. Today, due to the expansion of the programs and features in the household appliances, the number of relevant components also increases. This increase adversely affects the visual appearance of the household appliance and makes the use of the household appliance complex. Solutions such as touch screens used to overcome this situation cause the cost of the household appliance to increase.

In the state of the art Patent Application Document No. DE102005050592, a dishwasher is disclosed, comprising a touch panel.

The aim of the present invention is the realization of a household appliance which provides ease of utilization and cost advantage.

The household appliance realized in order to attain the aim of the present invention and explicated in the first and the respective claims thereof comprises a body; a control panel which is disposed on the body; a reflector which is provided on the control panel; a light source panel which is disposed behind the reflector; at least one silkscreen foil which is provided in front of the reflector and which has signs and information thereon; a glass which is disposed in front of the silkscreen foil; and a control unit which controls the operation of the programs. The light source passes over the reflector and the symbols and information on the silkscreen foil are reflected on the glass. A diffuser is disposed between the silkscreen foil and the glass. Thus, the symbols and information on the silkscreen foil are reflected without scattering the light.

The household appliance of the present invention comprises a button plate which is disposed between the reflector and the silkscreen foil. By means of the button plate, touch buttons are provided on the symbols on the silkscreen foil. thus, touch buttons are provided without using an additional guiding means or button.

In an embodiment of the present invention, the household appliance comprises the button plate which completely covers each cut-out. The button plate is positioned so as to cover the cut-outs on the reflector. Thus, illumination means can be used as touch buttons.

In an embodiment of the present invention, the household appliance comprises the button plate having a wicker structure. By means of the wicker structure, the permeability of light is not blocked and the symbols on the silkscreen foil are transmitted to the glass.

In an embodiment of the present invention, the household appliance comprises the button plate which is formed by knitting metal fibers. The button plate is formed by having a mesh structure of metal fibers. Thus, the permeability of light is not reduced and the perception of the touch button is provided.

By means of the present invention, a household appliance is realized, comprising a control panel which can be used as an illumination means and touch button by means of the button plate disposed on the cut-outs.

A household appliance realized in order to attain the aim of the present invention is illustrated in the attached figures, where:

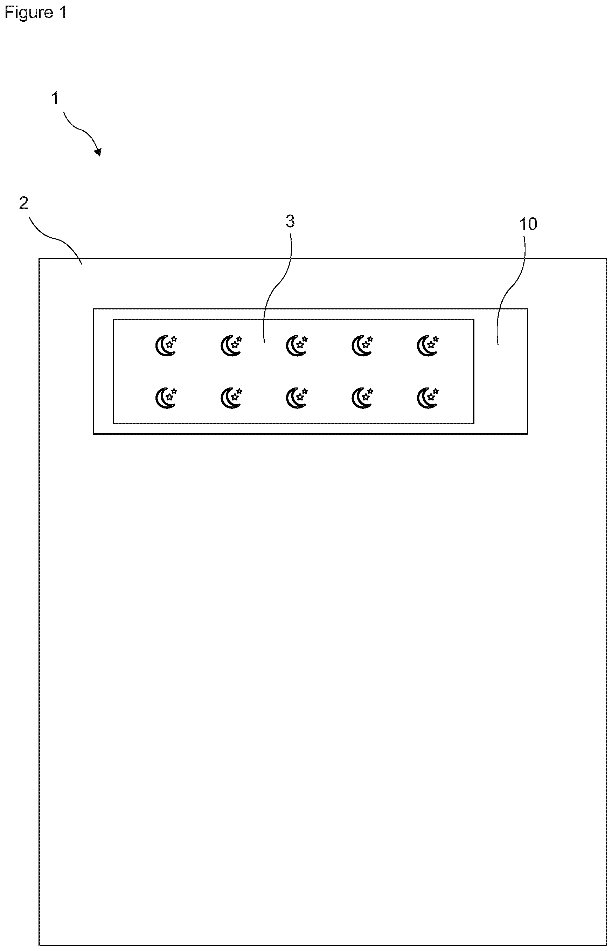

Figure 1 - is the schematic view of the household appliance.

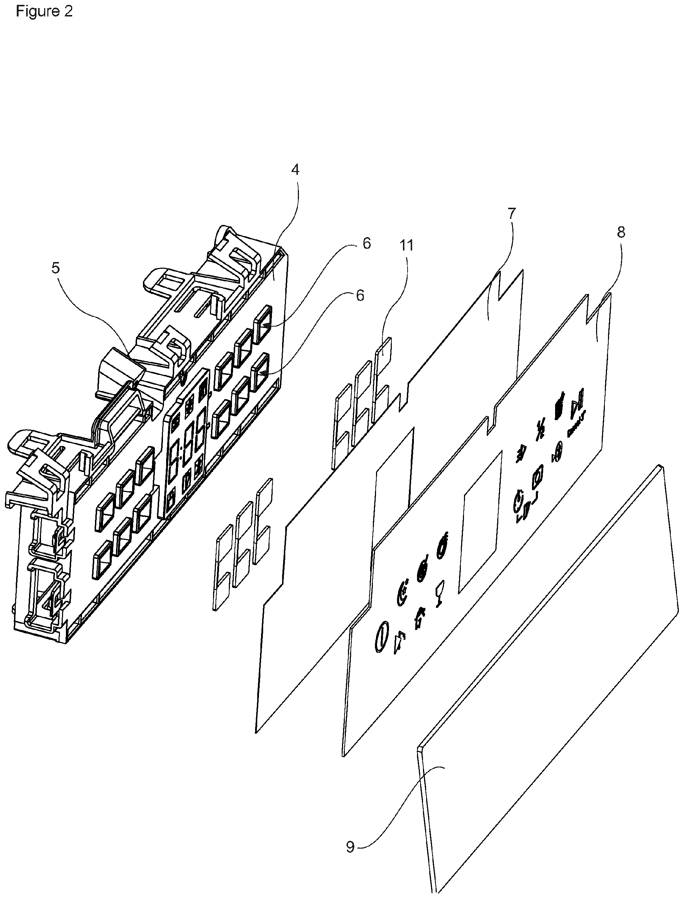

Figure 2 - is the exploded view of the control panel.

The elements illustrated in the figures are numbered as follows.
1- Household appliance
2- Body
3- Control panel
4- Reflector
5- Light source panel
6- Cut-out
7- Silkscreen foil
8- Diffuser
9- Glass
10- Control unit
11- Button plate

The household appliance (1) comprises a body (2); a control panel (3) which is disposed on the body (2) and which enables the user to control the programs; a reflector (4) which is provided on the control panel (3); a light source panel (5) which is disposed behind the reflector (4); a plurality of cut-outs (6) which are provided on the reflector (4) and which enable the light coming from the light source to be transmitted; at least one silkscreen foil (7) which is disposed in front of the reflector (4) and which has signs and information thereon; a diffuser (8) which is disposed in front of the silkscreen foil (7); a glass (9) which is disposed in front of the diffuser (8); and a control unit (10) which controls the operation of the programs. By means of the reflector (4) disposed on the control panel (3) and the cut-outs (6) provided on the reflector (4), the light coming from the light source is focused and transmitted. The light coming from the light source is focused and passes through the cut-outs (6) provided in front of the reflector (4) and the symbols and information on the silkscreen foil (7) are transmitted to the glass (9). The diffuser (8) disposed under the silkscreen foil (7) ensures that the light is transmitted without dispersion. The control unit (10) ensures that the household appliance (1) is operated in accordance with the selected symbol and information.

The household appliance (1) of the present invention comprises a button plate (11) which is disposed so as to completely cover each cut-out (6). The button plate (11) is placed on each cut-out (6). Thus, the light coming through the cut-out (6) passes through the button plate (11) to be transmitted onto the glass (9). Moreover, the light is also used as a touch button, thus providing cost advantage.

The household appliance (1) of the present invention comprises the button plate (11) having a wicker structure. By means of the wicker structure, the light passing through the cut-out (6) is enabled to be transmitted onto the glass (9). The quality of the touch button is prevented from changing over time by means of the non-removable wicker structure on the cut-outs (6).

The household appliance (1) of the present invention comprises the button plate (11) which is formed by knitting metal fibers. The mesh structure formed from metal fibers is placed on the cut-outs (6). By means of the button plate (11) having a mesh structure, the control panel (3) is used as an illumination means and touch button.

By means of the present invention, a household appliance (1) is realized, wherein the illumination means is used as touch button by means of the button plate (11) disposed between the reflector (4) and the silkscreen foil (7). Thus, cost is decreased and quality of use is improved.

## Claims

1. A household appliance (1) **comprising** a body (2); a control panel (3) which is disposed on the body (2) and which enables the user to control the programs; a reflector (4) which is provided on the control panel (3); a light source panel (5) which is disposed behind the reflector (4); a plurality of cut-outs (6) which are provided on the reflector (4) and which enable the light coming from the light source to be transmitted; at least one silkscreen foil (7) which is disposed in front of the reflector (4) and which has signs and information thereon; a diffuser (8) which is disposed in front of the silkscreen foil (7); a glass (9) which is disposed in front of the diffuser (8); and a control unit (10) which controls the operation of the programs, **characterized by** a button plate (11) disposed between the reflector (4) and the silkscreen foil (7).

2. A household appliance (1) as in Claim 1, **characterized by** the button plate (11) which is disposed so as to completely cover each cut-out (6).

3. A household appliance (1) as in Claim 1 or Claim 2, **characterized by** the button plate (11) having a wicker structure.

4. A household appliance (1) as in Claim 3, **characterized by** the button plate (11) formed by knitting metal fibers.
